# FASCICULE DE BREVET EUROPEEN

(11) **EP 0 777 322 B1**
(45) Date de publication et mention de la délivrance du brevet: **04.10.2001**
(21) Numéro de dépôt: 96203268.6
(22) Date de dépôt: 21.11.1996
(51) Int. Cl.: H03F 1/32

(54) **Amplificateur de tension à large plage de variation et convertisseur analogique/numérique comportant un tel amplificateur**
Spannungsverstärker mit grossen dynamischen Bereich und A/D-Konverter damit
Voltage amplifier with wide dynamic range and A/D converter using such amplifier

(30) Priorité: 29.11.1995 FR 9514131
(43) Date de publication de la demande: 04.06.1997
(73) Titulaire: Koninklijke Philips Electronics N.V., 5621 BA Eindhoven (NL)
(72) Inventeur: Guyot, Benoît, 75008 Paris (FR)
(74) Mandataire: Charpail, François

(56) Documents cités:
- EP-A- 0 312 017
- EP-A- 0 511 707
- DE-A- 4 038 217

## Description

La présente invention concerne un amplificateur de tension, destiné à recevoir une tension d'entrée et à fournir une tension de sortie, comportant un étage amplificateur incluant un premier et un deuxième transistors montés en paire différentielle, la base du premier transistor étant destinée à recevoir la tension d'entrée, la base du deuxième transistor étant destinée à recevoir une tension opposée à ladite tension d'entrée, le collecteur du premier transistor étant relié à une borne positive d'alimentation par une première branche comportant une charge résistive, le collecteur du deuxième transistor, destiné à fournir la tension de sortie, étant relié à la borne positive d'alimentation par une deuxième branche comportant une charge résistive.

Un tel amplificateur de tension est décrit dans le brevet américain n°4,904,952. Cet amplificateur de tension connu fournit un fort gain en tension, tout en ayant un bon comportement en fréquence. On constate toutefois que sa caractéristique de transfert perd de sa linéarité au voisinage des limites de la plage de variation de la tension de sortie. De plus, le nombre d'étages de transistors étant au minimum de trois entre les deux potentiels d'alimentation du circuit, cette plage de variation est nécessairement réduite, ce qui présente un inconvénient majeur dans les applications "basse tension".

La présente invention a pour but de remédier à ces inconvénients, en proposant un amplificateur de tension dont la linéarité de la caractéristique de transfert est améliorée au voisinage des limites de la plage de variation de la tension de sortie, tout en présentant un nombre limité d'étages de transistors entre les deux potentiels d'alimentation du circuit.

En effet, selon la présente invention, un amplificateur de tension du type défini dans le paragraphe introductif est caractérisé en ce que la première branche est formée d'au moins deux éléments résistifs montés en série, présentant ainsi entre eux au moins un premier noeud intermédiaire entre la borne positive d'alimentation et le collecteur du premier transistor, en ce que la deuxième branche est formée d'au moins deux éléments résistifs montés en série, présentant ainsi entre eux au moins un deuxième noeud intermédiaire entre la borne positive d'alimentation et le collecteur du deuxième transistor, et en ce qu'il est muni de moyens pour effectuer une comparaison entre le potentiel du deuxième noeud intermédiaire et celui du collecteur du premier transistor d'une part, et entre le potentiel du premier noeud intermédiaire et celui du collecteur du deuxième transistor d'autre part, et pour ajouter au courant débité dans une portion de la charge résistive de la deuxième branche, un premier courant qui s'annule progressivement lorsque le potentiel du deuxième noeud intermédiaire devient supérieur à celui du collecteur du premier transistor et un second courant qui s'annule progressivement lorsque le potentiel du collecteur du deuxième transistor devient supérieur à celui du premier noeud intermédiaire.

Un mode de réalisation particulièrement avantageux de l'invention présente un amplificateur de tension caractérisé en ce que les moyens de comparaison entre le potentiel du deuxième noeud intermédiaire et celui du collecteur du premier transistor d'une part, et entre le potentiel du premier noeud intermédiaire et celui du collecteur du deuxième transistor d'autre part, comprennent respectivement un troisième et un quatrième transistors montés en paire différentielle d'une part, un cinquième et un sixième transistors montés en paire différentielle d'autre part, la base du troisième transistor étant reliée au deuxième noeud intermédiaire, celle du quatrième transistor au collecteur du premier transistor, la base du cinquième transistor étant reliée au premier noeud intermédiaire, celle du sixième transistor au collecteur du deuxième transistor, les collecteurs des quatrième et cinquième transistors étant reliés au deuxième noeud intermédiaire.

Les paires différentielles additionnelles étant montées en parallèle avec l'étage amplificateur, l'amplificateur présente ainsi un nombre limité d'étages à transistors entre les deux bornes d'alimentation du circuit, la somme des chutes de tension aux bornes des divers transistors étant par conséquent elle aussi limitée, ce qui rend l'amplificateur particulièrement adapté aux applications "basses tensions".

Cet amplificateur de tension réalise une boucle de contre-réaction, utilisant la tension de sortie à des fins de comparaison afin de rendre l'évolution de ladite tension de sortie plus linéaire. Une variante de l'invention permet de régler les seuils de comparaison sans pour autant modifier de manière significative le gain de l'amplificateur.

Un tel amplificateur de tension est caractérisé en ce que la première branche est formée d'au moins trois éléments résistifs montés en série présentant ainsi à leurs bornes au moins un premier et un deuxième noeuds intermédiaires entre la borne positive d'alimentation et le collecteur du premier transistor, en ce que la deuxième branche est formée d'au moins trois éléments résistifs montés en série présentant ainsi à leurs bornes au moins un troisième et un quatrième noeuds intermédiaires entre la borne positive d'alimentation et le collecteur du deuxième transistor, en ce qu'il est muni de moyens pour effectuer une comparaison entre les potentiels du collecteur du premier transistor et du quatrième noeud intermédiaire d'une part, et ceux du collecteur du deuxième transistor et du deuxième noeud intermédiaire d'autre part, et pour ajouter au courant débité dans une portion de la charge résistive de la deuxième branche, un premier courant qui s'annule progressivement lorsque le potentiel du quatrième noeud intermédiaire devient supérieur à celui du collecteur du premier transistor et un second courant qui s'annule progressivement lorsque le potentiel du collecteur du deuxième transistor devient supérieur à celui du deuxième noeud intermédiaire.

Un mode de réalisation préféré de l'invention présente un amplificateur de tension caractérisé en outre en ce que les moyens de comparaison entre les potentiels du collecteur du premier transistor et du quatrième noeud intermédiaire d'une part, et les potentiels du collecteur du deuxième transistor et du deuxième noeud intermédiaire d'autre part, comprennent respectivement un troisième et un quatrième transistors montés en paire différentielle d'une part, un cinquième et un sixième transistors montés en paire différentielle d'autre part, la base du troisième transistor étant reliée au quatrième noeud intermédiaire, celle du quatrième transistor au collecteur du premier transistor, la base du cinquième transistor étant reliée au deuxième noeud intermédiaire, celle du sixième transistor au collecteur du deuxième transistor, les collecteurs des quatrième et cinquième transistors étant reliés à l'un des noeuds intermédiaires de la deuxième branche.

Dans une variante de ce mode de réalisation, l'amplificateur de tension est en outre caractérisé en ce que les collecteurs des quatrièmes et cinquième transistors sont reliés au troisième noeud intermédiaire.

La portion de la charge résistive dans laquelle circulent, en plus du courant de fonctionnement normal de l'étage amplificateur, le ou les courants ajoutés par les paires différentielles additionnelles est ainsi limitée, ce qui a pour effet de limiter, en termes de chute de tension, les perturbations provoquées sur les potentiels des noeuds intermédiaires dont les valeurs sont exploitées par lesdites paires additionnelles.

Une variante de l'amplificateur de tension selon l'invention est caractérisée en ce que les éléments résistifs séparant les premiers et deuxième noeuds intermédiaires d'une part, et les troisième et quatrième noeuds intermédiaires d'autre part, ont une même valeur nominale appelée R, en ce que les éléments résistifs séparant la borne positive d'alimentation du premier noeud intermédiaire d'une part, et la borne positive d'alimentation du troisième noeud intermédiaire d'autre part, ont une même valeur nominale, laquelle est inférieure à R, et en ce que les éléments résistifs séparant le deuxième noeud intermédiaire du collecteur du premier transistor d'une part, et le quatrième noeud intermédiaire du collecteur du deuxième transistor d'autre part, ont une même valeur nominale, laquelle est inférieure à R.

Ce choix des valeurs des éléments résistifs permet de mieux délimiter les zones de la caractéristique de transfert où les corrections de non-linéarité sont effectuées.

Une autre variante de l'amplificateur de tension selon l'invention est caractérisée en ce que les éléments résistifs séparant les premiers et deuxième noeuds intermédiaires d'une part, et les troisième et quatrième noeuds intermédiaires d'autre part, ont une même valeur nominale appelée R, en ce que les éléments résistifs séparant la borne positive d'alimentation du premier noeud intermédiaire, et le deuxième noeud intermédiaire du collecteur du premier transistor, ainsi que ceux séparant la borne positive d'alimentation du troisième noeud intermédiaire, et le quatrième noeud intermédiaire du collecteur du deuxième transistor ont une même valeur nominale, laquelle est inférieure à R.

Un amplificateur selon l'invention présente, outre l'avantage de disposer d'une caractéristique de transfert à linéarité améliorée sur une plus large plage de variation de la tension d'entrée, celui de fournir une sortie unique, non différentielle, ce qui le rend particulièrement adapté à des applications de type conversion analogique/numérique, où la tension de sortie de l'amplificateur est comparée à une gamme de tensions de référence, elles aussi de nature non différentielle.

L'invention concerne donc également un convertisseur analogique/numérique, destiné à recevoir une tension d'entrée analogique de nature différentielle à convertir en un signal de sortie numérique, comprenant :
. un amplificateur d'entrée destiné à recevoir la tension d'entrée analogique, et à fournir une tension de sortie analogique,
. une échelle de résistances placées en série entre une borne positive et une borne négative d'alimentation, résistances destinées à fournir à leurs noeuds intermédiaires une pluralité de tensions dites de référence,
. un étage de comparateurs, chacun destiné à effectuer une comparaison de la tension de sortie de l'amplificateur d'entrée avec l'une des tensions de référence,
. un étage de mémorisation destiné à mémoriser les résultats desdites comparaisons,
. un encodeur binaire, destiné à recevoir les informations mémorisées dans l'étage de mémorisation et à fournir le signal de sortie numérique du convertisseur,
caractérisé en ce que l'amplificateur d'entrée est tel que décrit plus haut.

L'invention sera mieux comprise à l'aide de la description suivante de quelques modes de réalisation de l'invention, faite à titre d'exemple, et en regard des dessins annexés, dans lesquels :
- la figure 1 est un schéma fonctionnel partiel d'un amplificateur de tension selon l'invention,
- la figure 2 est un schéma fonctionnel partiel d'un amplificateur de tension selon un mode de réalisation avantageux de l'invention,
- la figure 3 est un schéma fonctionnel partiel d'un amplificateur de tension selon une variante de l'invention,
- la figure 4 est un schéma fonctionnel partiel d'un amplificateur de tension selon un mode de réalisation préféré de l'invention,
- la figure 5 est un ensemble de caractéristiques décrivant l'évolution des potentiels des noeuds intermédiaires, en fonction de la tension d'entrée de l'amplificateur,
- la figure 6 est une caractéristique décrivant l'évolution du premier courant ajouté dans une portion de la charge résistive, en fonction de la tension d'entrée de l'amplificateur,
- la figure 7 est une caractéristique décrivant l'évolution du deuxième courant ajouté dans une portion de la charge résistive, en fonction de la tension d'entrée de l'amplificateur,
- la figure 8 est un ensemble de caractéristiques décrivant l'évolution du courant dans ladite portion de la charge résistive, en fonction de la tension d'entrée de l'amplificateur,
- la figure 9 est une caractéristique décrivant l'évolution de la tension de sortie, en fonction de la tension d'entrée de l'amplificateur,
- la figure 10 est une caractéristique décrivant l'évolution de la dérivée de la tension de sortie, en fonction de la tension d'entrée de l'amplificateur, et
- la figure 11 est un schéma fonctionnel partiel d'un convertisseur analogique/numérique comprenant un amplificateur de tension selon l'invention.

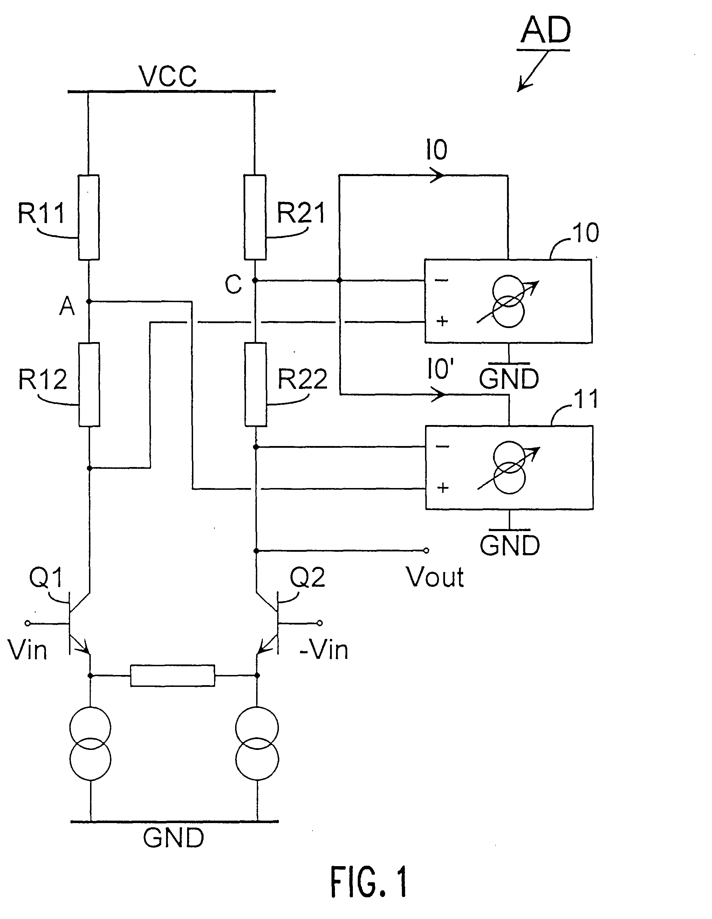

La figure 1 décrit schématiquement un amplificateur de tension AD selon l'invention. Deux transistors Q1 et Q2 sont montés en paire différentielle : l'émetteur du transistor Q1 est relié à une des bornes d'une résistance, l'émetteur du transistor Q2 étant relié à l'autre borne de la même résistance. Chacun des deux émetteurs est relié à une borne d'une source de courant, l'autre borne de ladite source de courant étant reliée à une borne négative d'alimentation, appelée GND. La base du transistor Q1 reçoit la tension d'entrée de l'amplificateur de tension, appelée Vin, la base du transistor Q2 recevant l'opposée de ladite tension d'entrée, soit -Vin. Le collecteur du premier transistor Q1 est relié à une borne positive d'alimentation, appelée VCC, par une première branche comportant une charge résistive, le collecteur du deuxième transistor Q2, fournissant la tension de sortie appelée Vout, étant relié à la borne positive d'alimentation VCC par une deuxième branche comportant une charge résistive. La première branche est formée d'au moins deux éléments résistifs, appelés R11 et R12, montés en série et présentant ainsi entre eux au moins un premier noeud intermédiaire, appelé A, entre la borne positive d'alimentation VCC et le collecteur du premier transistor Q1. La deuxième branche est formée d'au moins deux éléments résistifs, appelés R21 et R22, montés en série et présentant entre eux au moins un deuxième noeud intermédiaire, appelé C, entre la borne positive d'alimentation VCC et le collecteur du deuxième transistor Q2.

L'amplificateur de tension AD est muni de moyens 10 et 11 pour effectuer une comparaison entre le potentiel du deuxième noeud intermédiaire C et celui du collecteur du premier transistor Q1 d'une part, et entre le potentiel du premier noeud intermédiaire A et celui du collecteur du deuxième transistor Q2 d'autre part. Ces mêmes moyens permettent d'ajouter au courant débité dans une portion de la charge résistive de la deuxième branche, R21, un premier courant IO qui s'annule progressivement lorsque le potentiel du deuxième noeud intermédiaire C devient supérieur à celui du collecteur du premier transistor Q1 d'une part, et un second courant IO' qui s'annule progressivement lorsque le potentiel du collecteur du deuxième transistor Q2 devient supérieur à celui du premier noeud intermédiaire A.

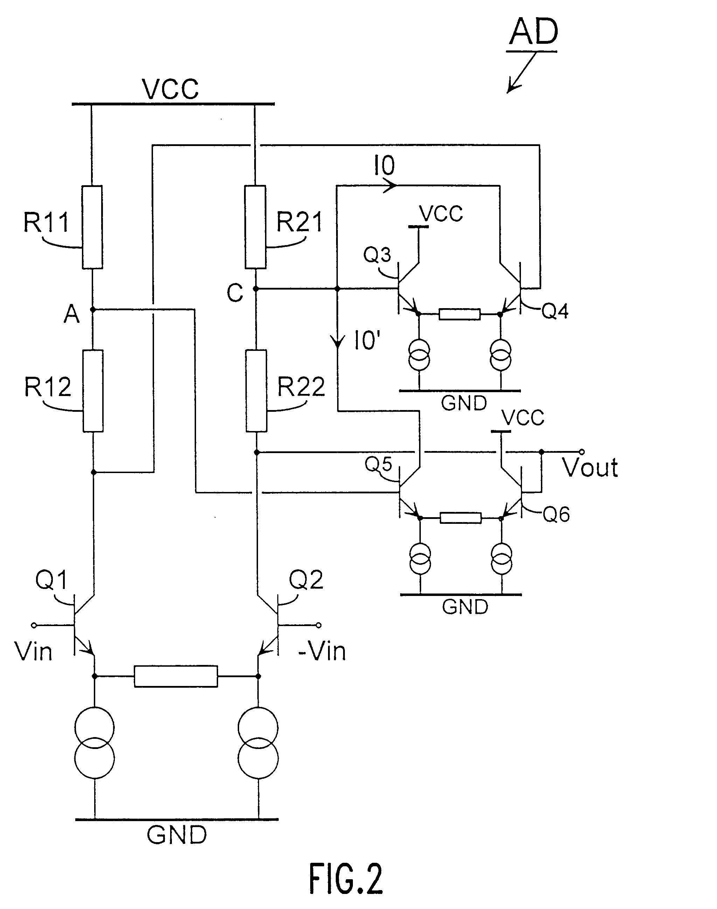

La figure 2 décrit schématiquement un amplificateur de tension AD selon un mode de réalisation avantageux de l'invention. Les structures de l'étage amplificateur et des branches comportant les charges résistives sont identiques à celles décrites à la figure 1. Un mode de réalisation des moyens 10 et 11 y est en outre exposé : ils comprennent respectivement un troisième transistor Q3 et un quatrième transistor Q4, montés en paire différentielle, et un cinquième transistor Q5 et un sixième transistor Q6, montés en paire différentielle. La base du troisième transistor Q3 est reliée au deuxième noeud intermédiaire C, celle du quatrième transistor Q4 au collecteur du premier transistor Q1, la base du cinquième transistor Q5 est reliée au premier noeud intermédiaire A, celle du sixième transistor Q6 au collecteur du deuxième transistor Q2. Les collecteurs des troisième et sixième transistors Q3 et Q6 sont reliés à la borne positive d'alimentation VCC, et ceux des quatrième et cinquième transistors Q4 et Q5 au deuxième noeud intermédiaire C.

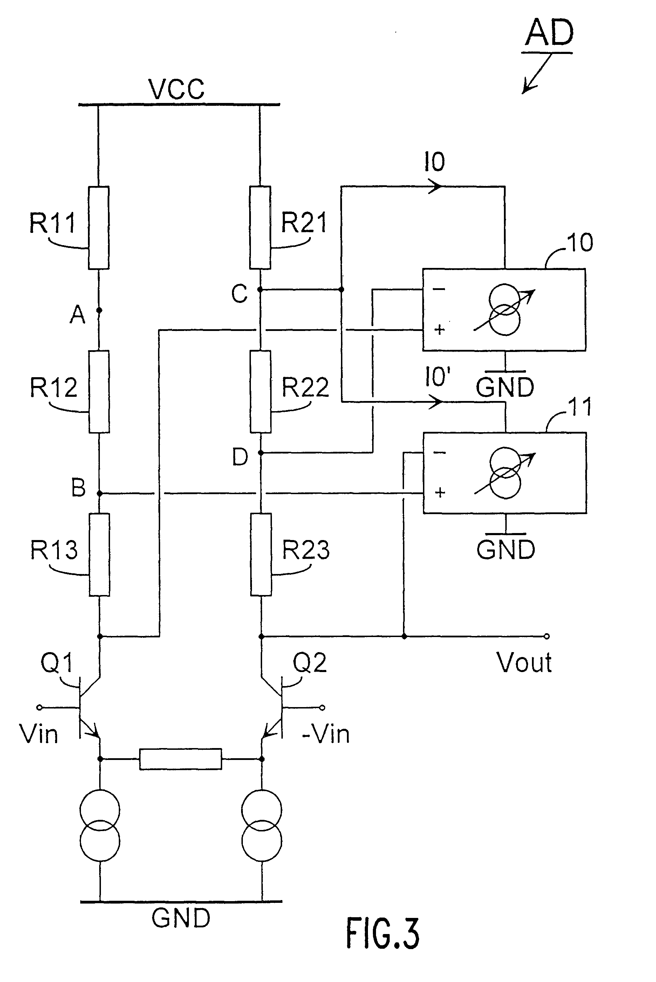

La figure 3 décrit schématiquement un amplificateur de tension AD selon une variante de l'invention. Deux transistors Q1 et Q2 sont montés en paire différentielle : L'émetteur du transistor Q1 est relié à une des bornes d'une résistance, l'émetteur du transistor Q2 étant relié à l'autre borne de la même résistance. Chacun des deux émetteurs est relié à une borne d'une source de courant, l'autre borne de ladite source de courant étant reliée à une borne négative d'alimentation, appelée GND. La base du transistor Q1 reçoit la tension d'entrée de l'amplificateur de tension, appelée Vin, la base du transistor Q2 recevant l'opposée de ladite tension d'entrée, soit -Vin. Le collecteur du premier transistor Q1 est relié à une borne positive d'alimentation, appelée VCC, par une première branche comportant une charge résistive, le collecteur du deuxième transistor Q2, fournissant la tension de sortie appelée Vout, étant relié à la même borne positive d'alimentation VCC par une deuxième branche comportant une charge résistive. La première branche est formée d'au moins trois éléments résistifs, appelés R11, R12 et R13, montés en série et présentant ainsi à leurs bornes au moins un premier et un deuxième noeuds intermédiaires, respectivement appelés A et B, entre la borne positive d'alimentation VCC et le collecteur du premier transistor Q1. La deuxième branche est formée d'au moins trois éléments résistifs, appelés R21, R22 et R23, montés en série et présentant ainsi à leurs bornes au moins un troisième et un quatrième noeuds intermédiaires, respectivement appelés C et D, entre la borne positive d'alimentation VCC et le collecteur du deuxième transistor Q2.

L'amplificateur de tension AD est muni de moyens 10 et 11 pour effectuer une comparaison entre les potentiels du collecteur du premier transistor Q1 et du quatrième noeud intermédiaire D, respectivement appelés VC1 et VD, d'une part, et ceux du collecteur du deuxième transistor Q2 et du deuxième noeud intermédiaire B, respectivement appelés VC2 et VB, d'autre part. Ces mêmes moyens permettent d'ajouter au courant débité dans une portion de la charge résistive de la deuxième branche, R21, un premier courant IO qui s'annule progressivement lorsque le potentiel du quatrième noeud intermédiaire VD devient supérieur à celui du collecteur du premier transistor VC1 et un second courant IO' qui s'annule progressivement lorsque le potentiel du collecteur du deuxième transistor VC2 devient supérieur à celui du deuxième noeud intermédiaire VB.

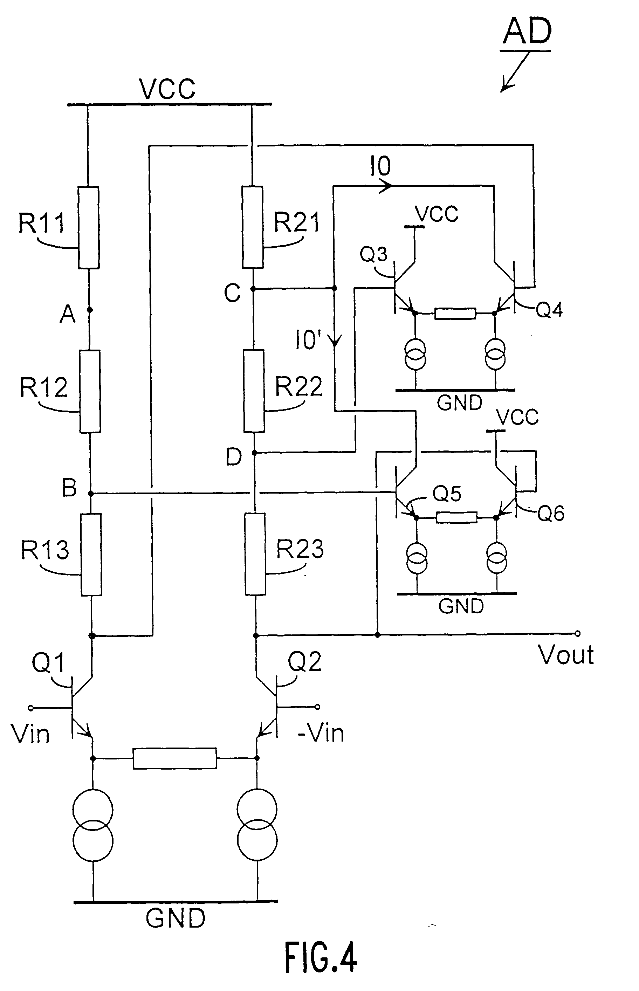

La figure 4 décrit schématiquement un amplificateur de tension AD selon un mode de réalisation préféré de l'invention. Les structures de l'étage amplificateur et des branches comportant les charges résistives sont identiques à celles décrites à la figure 3. Un mode de réalisation des moyens 10 et 11 y est en outre exposé : ils comprennent respectivement un troisième transistor Q3 et un quatrième transistor Q4, montés en paire différentielle, et un cinquième transistor Q5 et un sixième transistor Q6, montés en paire différentielle. La base du troisième transistor Q3 est reliée au quatrième noeud intermédiaire D, celle du quatrième transistor Q4 au collecteur du premier transistor Q1, la base du cinquième transistor Q5 est reliée au deuxième noeud intermédiaire B, celle du sixième transistor Q6 au collecteur du deuxième transistor Q2. Les collecteurs des troisième et sixième transistors Q3 et Q6 sont reliés à la borne positive d'alimentation VCC, et ceux des quatrième et cinquième transistors Q4 et Q5 à l'un des noeuds intermédiaires de la deuxième branche. Dans le mode de réalisation décrit par la figure 4, les collecteurs des quatrième et cinquième transistors, Q4 et Q5, sont reliés au troisième noeud intermédiaire C.

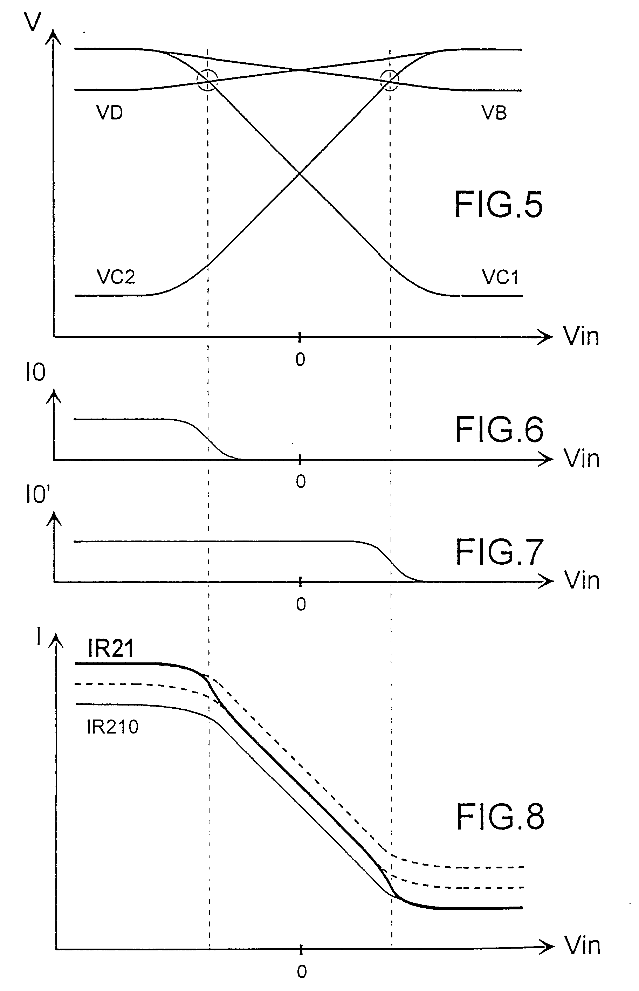

Les figures 5 à 9 décrivent l'évolution de divers signaux internes à l'amplificateur AD en fonction de la tension d'entrée de celui-ci, afin de faciliter la compréhension de son fonctionnement.

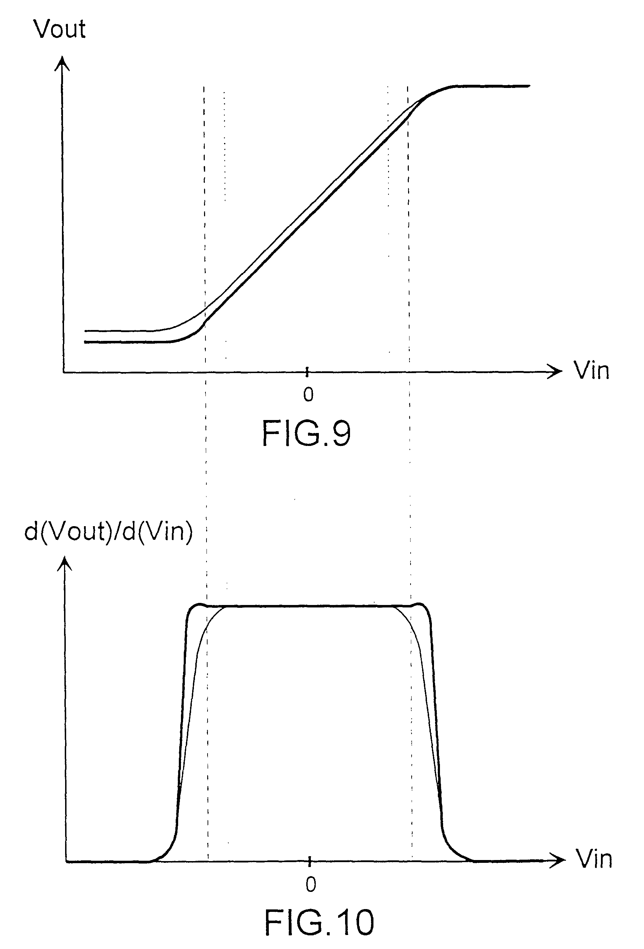

La figure 5 décrit l'évolution des potentiels VB, VC1, VD et VC2, en fonction de la tension d'entrée Vin de l'amplificateur AD. Les figures 6 et 7 décrivent l'évolution des premier et deuxième courants, respectivement IO et IO', ajoutés dans une portion de la charge résistive, dans ce cas R21, en fonction de la tension d'entrée Vin de l'amplificateur AD. La figure 8 décrit l'évolution du courant total dans ladite portion de la charge résistive R21 en fonction de la tension d'entrée Vin de l'amplificateur AD. La courbe IR210 y représente le courant qui circulerait dans la deuxième branche si les moyens 10 et 11 n'existaient pas, c'est-à-dire dans le cas de la paire différentielle classique. Les courbes en pointillés y représentent les courants qui circuleraient dans la portion de la charge résistive R21, si, dans un premier cas, la valeur maximale du courant IO était ajoutée au courant IR210, et si, dans un deuxième cas, la valeur maximale du courant IO' était ajoutée au courant précédemment obtenu. La figure 9 décrit en trait gras l'évolution de la tension de sortie Vout en fonction de la tension d'entrée Vin d'un amplificateur selon l'invention, la courbe en trait fin décrivant, elle, l'évolution de la tension de sortie d'une paire différentielle classique.

Lorsque Vin est négatif et grand en valeur absolue, le transistor Q1 est très peu conducteur alors que le transistor Q2 est très conducteur. Le courant dans la première branche est donc très faible, alors que le courant dans la deuxième branche est important. Les chutes de tension dans les résistances R11 et R12 sont négligeables, alors que les chutes de tension dans les résistances R21 et R22 sont significatives. On observe sur la figure 5 que VC1 est alors nettement supérieur à VD. Le transistor Q3 est donc peu conducteur alors que le transistor Q4 est très conducteur et fait passer un courant IO au travers de la résistance R21. VB étant nettement supérieur à VC2, le transistor Q6 est peu conducteur alors que le transistor Q5 est très conducteur et fait passer un courant IO' supplémentaire au travers de la résistance R21. Le courant total IR21 circulant au travers de la résistance R21 est décrit par la figure 8. Le courant circulant dans la deuxième branche étant à son niveau maximal, la tension de sortie est alors à son niveau le plus bas, comme le montre la figure 9, et la chute de tension additionnelle générée dans R21 par les courants ajoutés IO et IO' explique la différence de valeur entre le niveau bas de la tension de sortie Vout d'un amplificateur selon l'invention et celui de la tension de sortie de la paire différentielle classique.

Lorsque Vin augmente, tout en restant négatif, la première zone de fonctionnement non-linéaire de l'étage amplificateur classique est atteinte : le transistor Q1 conduit plus, alors que le transistor Q2 conduit moins, le courant circulant dans la première branche augmente alors que le courant circulant dans la deuxième branche diminue. Les potentiels VC1 et VD se rapprochent, augmentant la conduction de Q3 et diminuant la conduction de Q4, provoquant l'annulation progressive du courant IO passant au travers de la résistance R21.

Tout au long de la portion linéaire, qui correspond au changement de signe de Vin, le transistor Q6 reste peu conducteur alors que le transistor Q5 reste très conducteur, et maintient la circulation du courant IO' au travers de la résistance R21.

Lorsque Vin augmente, la deuxième zone de fonctionnement non-linéaire de l'étage amplificateur classique est atteinte : le transistor Q1 conduit encore plus alors que le transistor Q2 conduit encore moins, le courant circulant dans la première branche augmente alors que le courant circulant dans la deuxième branche diminue. Les potentiels VC2 et VB se rapprochent, augmentant la conduction de Q6 et diminuant la conduction de Q5, provoquant l'annulation progressive du courant IO' passant au travers de la résistance R21.

Enfin, lorsque Vin est grand, le transistor Q2 est très peu conducteur alors que le transistor Q1 est très conducteur. Le courant dans la deuxième branche est donc très faible, alors que le courant dans la première branche est important. Les chutes de tension dans les résistances R21 et R22 sont négligeables, alors que les chutes de tension dans les résistances R11 et R12 sont significatives. Le courant circulant dans la deuxième branche étant presque nul, la tension de sortie Vout est alors à son niveau le plus haut, comme le montre la figure 9.

Cette figure montre l'influence des paires additionnelles de transistors dans les zones de non-linéarité de la caractéristique de la tension de sortie. En effet, dans la première zone non-linéaire, où Vout augmente trop tôt avec Vin dans le cas de la paire différentielle classique, l'ajout des courants IO et IO' maintient artificiellement Vout au niveau bas plus longtemps, puis la diminution progressive de IO permet à Vout d'augmenter quasi-linéairement. De même, dans la deuxième zone non-linéaire, où Vout augmente trop lentement avec Vin dans le cas de la paire différentielle classique, l'ajout du courant IO' maintient artificiellement Vout à un niveau intermédiaire plus longtemps, puis la diminution progressive de IO' permet à Vout d'augmenter quasi-linéairement.

De la sorte, la zone où la tension de sortie évolue linéairement en fonction de la tension d'entrée est élargie. On peut observer ce résultat sur la figure 10, où l'on voit deux caractéristiques d(Vin)/d(Vout) en fonction de la tension d'entrée Vin, l'une en trait fin correspondant à une paire différentielle classique, et l'autre en trait gras correspondant à un amplificateur selon l'invention. La partie "plate", où la dérivée de la tension de sortie Vout par rapport à la tension d'entrée Vin est constante, correspond à la partie où la tension de sortie évolue linéairement en fonction de la tension d'entrée. La zone ainsi délimitée est clairement plus large pour un amplificateur de tension selon l'invention que pour une paire différentielle classique.

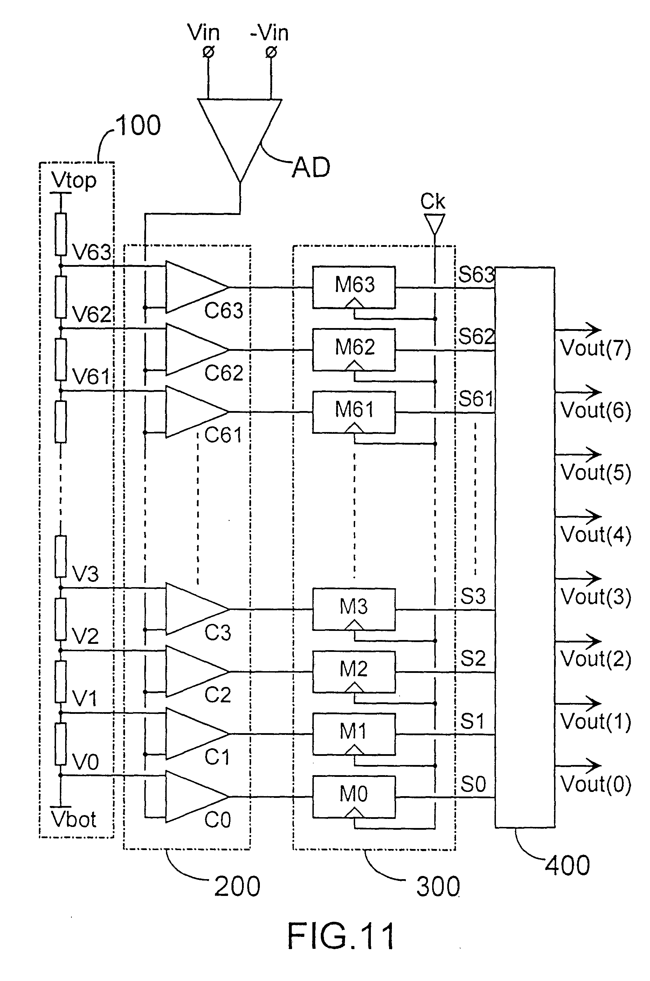

La figure 11 représente partiellement un convertisseur analogique/numérique qui comporte un amplificateur de tension AD conforme à l'une des variantes représentées sur les figures 1, 2, 3 et 4. Dans le cas présent, ce convertisseur reçoit une tension d'entrée analogique de nature différentielle (Vin, -Vin) à convertir en un signal de sortie numérique codé sur 8 bits Vout(0...7). Ce convertisseur comprend :
. l'amplificateur d'entrée AD recevant la tension d'entrée analogique (Vin, -Vin), et fournissant une tension de sortie analogique,
. une échelle de résistances 100, formée de 64 résistances placées en série entre une borne positive et une borne négative d'alimentation, respectivement Vtop et Vbot, résistances fournissant à leurs noeuds intermédiaires 64 tensions dites de référence, V0, V1,...V63, V0 étant égale à Vbot.
. un étage de comparateurs 200, formé de 64 comparateurs, chacun réalisant la comparaison de la tension de sortie de l'amplificateur d'entrée AD avec l'une des tensions de référence V0, V1,...V63,
. un étage de mémorisation 300 composé d'éléments de mémorisation dits cellules mémoire M0, M1,...M63, chaque cellule mémoire Mi (pour i=0 à 63) étant munie d'une entrée de données, d'une sortie et d'une entrée d'horloge, et recevant sur son entrée de données le signal de sortie Ci d'un comparateur, toutes les cellules mémoire M0, M1,...M63 composant l'étage de mémorisation 300 recevant sur leurs entrées d'horloge un même signal Ck dit signal d'horloge,
. un encodeur binaire 400, lequel encodeur 400 reçoit en entrée les sorties S0, S1,...S63 de l'étage de mémorisation 300 et fournit le signal de sortie numérique du convertisseur Vout(0...7).

## Revendications

1. Amplificateur de tension (AD), destiné à recevoir une tension d'entrée (Vin) et à fournir une tension de sortie (Vout), comportant un étage amplificateur incluant un premier et un deuxième transistors (Q1,Q2) montés en paire différentielle, la base du premier transistor (Q1) étant destinée à recevoir la tension d'entrée (Vin), la base du deuxième transistor (Q2) étant destinée à recevoir une tension (-Vin) opposée à ladite tension d'entrée (Vin), le collecteur du premier transistor (Q1) étant relié à une borne positive d'alimentation (VCC) par une première branche comportant une charge résistive, le collecteur du deuxième transistor (Q2), destiné à fournir la tension de sortie (Vout), étant relié à la même borne positive d'alimentation (Vcc) par une deuxième branche comportant une charge résistive, amplificateur de tension (AD) **caractérisé en ce que** la première branche est formée d'au moins deux éléments résistifs (R11,R12) montés en série, présentant ainsi entre eux au moins un premier noeud intermédiaire (A) entre la borne positive d'alimentation (VCC) et le collecteur du premier transistor (Q1), **en ce que** la deuxième branche est formée d'au moins deux éléments résistifs (R21,R22) montés en série, présentant ainsi entre eux au moins un deuxième noeud intermédiaire (C) entre la borne positive d'alimentation (VCC) et le collecteur du deuxième transistor (Q2), **en ce qu'**il est muni de moyens (10,11) pour effectuer une comparaison entre le potentiel du deuxième noeud intermédiaire (C) et celui du collecteur du premier transistor (Q1) d'une part, et entre le potentiel du premier noeud intermédiaire (A) et celui du collecteur du deuxième transistor (Q2) d'autre part, et pour ajouter au courant débité dans une portion de la charge résistive de la deuxième branche, un premier courant (IO) qui s'annule progressivement lorsque le potentiel du deuxième noeud intermédiaire (C) devient supérieur à celui du collecteur du premier transistor (Q1) et un second courant (IO') qui s'annule progressivement lorsque le potentiel du collecteur du deuxième transistor (Q2) devient supérieur à celui du premier noeud intermédiaire (A).

2. Amplificateur de tension selon la revendication 1,
**caractérisé en ce que** les moyens de comparaison (10,11) entre le potentiel du deuxième noeud intermédiaire (C) et celui du collecteur du premier transistor (Q1) d'une part, et entre le potentiel du premier noeud intermédiaire (A) et celui du collecteur du deuxième transistor (Q2) d'autre part, comprennent respectivement un troisième et un quatrième transistors (Q3,Q4) montés en paire différentielle d'une part, un cinquième et un sixième transistors (Q5,Q6) montés en paire différentielle d'autre part, la base du troisième transistor (Q3) étant reliée au deuxième noeud intermédiaire (C), celle du quatrième transistor (Q4) au collecteur du premier transistor (Q1), la base du cinquième transistor (Q5) étant reliée au premier noeud intermédiaire (A), celle du sixième transistor (Q6) au collecteur du deuxième transistor (Q2), les collecteurs des quatrième et cinquième transistors (Q4,Q5) étant reliés au deuxième noeud intermédiaire (C).

3. Amplificateur de tension (AD), destiné à recevoir une tension d'entrée (Vin) et à fournir une tension de sortie (Vout), comportant un étage amplificateur incluant un premier et un deuxième transistors (Q1,Q2) montés en paire différentielle, le premier transistor (Q1) destiné à recevoir sur sa base la tension d'entrée, le deuxième transistor (Q2) destiné à recevoir sur sa base une tension (-Vin) opposée à ladite tension d'entrée (Vin), le collecteur du premier transistor (Q1) étant relié à une borne positive d'alimentation (VCC) par une première branche comportant une charge résistive, le collecteur du deuxième transistor (Q2), destiné à fournir la tension de sortie (Vout), étant relié à la même borne positive d'alimentation (VCC) par une deuxième branche comportant une charge résistive, **caractérisé en ce que** la première branche est formée d'au moins trois éléments résistifs (R11,R12,R13) montés en série présentant ainsi à leurs bornes au moins un premier et un deuxième noeuds intermédiaires (A,B) entre la borne positive d'alimentation (VCC) et le collecteur du premier transistor (Q1), **en ce que** la deuxième branche est formée d'au moins trois éléments résistifs (R21,R22,R23) montés en série présentant ainsi à leurs bornes au moins un troisième et un quatrième noeuds intermédiaires (C,D) entre la borne positive d'alimentation (VCC) et le collecteur du deuxième transistor (Q2), **en ce qu'**il est muni de moyens (10,11) pour effectuer une comparaison entre les potentiels du collecteur du premier transistor (Q1) et du quatrième noeud intermédiaire (D) d'une part, et ceux du collecteur du deuxième transistor (Q2) et du deuxième noeud intermédiaire (B) d'autre part, et pour ajouter au courant débité dans une portion de la charge résistive de la deuxième branche, un premier courant (IO) qui s'annule progressivement lorsque le potentiel du quatrième noeud intermédiaire (D) devient supérieur à celui du collecteur du premier transistor (Q1) et un second courant (IO') qui s'annule progressivement lorsque le potentiel du collecteur du deuxième transistor (Q2) devient supérieur à celui du deuxième noeud intermédiaire (B).

4. Amplificateur de tension (AD) selon la revendication 3,
**caractérisé en ce que** les moyens de comparaison (10,11) entre les potentiels du collecteur du premier transistor (Q1) et du quatrième noeud intermédiaire (D) d'une part, et les potentiels du collecteur du deuxième transistor (Q2) et du deuxième noeud intermédiaire (B) d'autre part, comprennent respectivement un troisième et un quatrième transistors (Q3,Q4) montés en paire différentielle d'une part, un cinquième et un sixième transistors (Q5,Q6) montés en paire différentielle d'autre part, la base du troisième transistor (Q3) étant reliée au quatrième noeud intermédiaire (D), celle du quatrième transistor (Q4) au collecteur du premier transistor (Q1), la base du cinquième transistor (Q5) étant reliée au deuxième noeud intermédiaire (B), celle du sixième transistor (Q6) au collecteur du deuxième transistor (Q2), les collecteurs des quatrième et cinquième transistors (Q4,Q5) étant reliés à l'un des noeuds intermédiaires de la deuxième branche.

5. Amplificateur de tension selon la revendication 4,
**caractérisé en ce que** les collecteurs des quatrième et cinquième transistors (Q4,Q5) sont reliés au troisième noeud intermédiaire (C).

6. Amplificateur de tension (AD) selon l'une des revendications 3 à 5, **caractérisé en ce que** les éléments résistifs (R12,R22) séparant les premier et deuxième noeuds intermédiaires (A,B) d'une part, et les troisième et quatrième noeuds intermédiaires (C,D) d'autre part, ont une même valeur nominale appelée R, **en ce que** les éléments résistifs (R11,R21) séparant la borne positive d'alimentation (VCC) du premier noeud intermédiaire (A) d'une part, et la borne positive d'alimentation (VCC) du troisième noeud intermédiaire (C) d'autre part, ont une même valeur nominale, laquelle est inférieure à R, et **en ce que** les éléments résistifs (R13,R23) séparant le deuxième noeud intermédiaire (B) du collecteur du premier transistor (Q1) d'une part, et le quatrième noeud intermédiaire (D) du collecteur du deuxième transistor (Q2) d'autre part, ont une même valeur nominale, laquelle est inférieure à R.

7. Amplificateur de tension (AD) selon l'une des revendications 3 à 5, **caractérisé en ce que** les éléments résistifs (R12,R22) séparant les premier et deuxième noeuds intermédiaires (A,B) d'une part, et les troisième et quatrième noeuds intermédiaires (C,D) d'autre part, ont une même valeur nominale appelée R, **en ce que** les éléments résistifs (R11,R13,R21,R23) séparant la borne positive d'alimentation (VCC) du premier noeud intermédiaire (A), et le deuxième noeud intermédiaire (B) du collecteur du premier transistor (Q1), ainsi que ceux séparant la borne positive d'alimentation (VCC) du troisième noeud intermédiaire (C), et le quatrième noeud intermédiaire (D) du collecteur du deuxième transistor (Q2) ont une même valeur nominale, laquelle est inférieure à R.

8. Amplificateur de tension (AD) selon l'une des revendications 1 à 7, **caractérisé en ce que** les éléments résistifs qui constituent la charge de l'étage amplificateur sont des résistances.

9. Convertisseur analogique/numérique, destiné à recevoir une tension d'entrée analogique (Vin-Vin) de nature différentielle à convertir en un signal de sortie numérique (Vout (0:7)), comprenant :
. un amplificateur d'entrée (AD) destiné à recevoir la tension d'entrée analogique (Vin-Vin), et à fournir une tension de sortie analogique,
. une échelle (100) de résistances placées en série entre une borne positive (Vtop) et une borne négative (Vbot) d'alimentation, résistances destinées à fournir à leurs noeuds intermédiaires une pluralité de tensions (V0,...V63) dites de référence,
. un étage de comparateurs (200), chacun destiné à effectuer une comparaison de la tension de sortie de l'amplificateur d'entrée avec l'une des tensions de référence,
. un étage de mémorisation (300) destiné à mémoriser les résultats desdites comparaisons,
. un encodeur binaire (400), destiné à recevoir les informations mémorisées dans l'étage de mémorisation (300) et à fournir le signal de sortie numérique (Vout (0:7)) du convertisseur,
**caractérisé en ce que** l'amplificateur d'entrée (AD) est conforme à l'une quelconque des revendications 1 à 8.

## Patentansprüche

1. Spannungsverstärker (AD) zum Empfangen einer Eingangsspannung (Vin) und zum Liefern einer Ausgangsspannung (Vout), mit einer Verstärkerstufe, die einen ersten und einen zweiten Transistor (Q1, Q2) aufweist, als Differentialpaar geschaltet, während die Basis des ersten Transistors (Q1) dazu bestimmt ist, die Eingangsspannung (Vin) zu erhalten, die Basis des zweiten Transistors (Q2) dazu bestimmt ist, eine zur besagten Eingangsspannung (Vin) umgekehrte Spannung (-Vin) zu erhalten, der Kollektor des ersten Transistors (Q1) über eine positive Versorgungsklemme (VCC) mit einem ersten Zweig verbunden ist, der eine ohmsche Ladung aufweist, der Kollektor des zweiten Transistors (Q2), dazu bestimmt, die Ausgangsspannung (Vout) zu liefern, über eine positive Versorgungsklemme (VCC) mit einem zweiten Zweig verbunden ist, der eine ohmsche Ladung aufweist, ein Spannungsverstärker (AD), **dadurch gekennzeichnet, daß** der erste Zweig aus mindesten zwei in Serie geschalteten ohmschen Elementen (R11, R12) gebildet wird, die so zwischen sich mindestens einen ersten Zwischenknoten (A) zwischen der positiven Versorgungsklemme (VCC) und dem Kollektor des ersten Transistors (Q1) bilden, **daß** der zweite Zweig aus mindestens zwei in Serie geschalteten ohmschen Elementen (R21, R22) gebildet wird, die so zwischen sich mindestens einen zweiten Zwischenknoten (C) zwischen der positiven Versorgungsklemme (VCC) und dem Kollektor des zweiten Transistors (Q2) bilden, und dadurch, **daß** er mit Mitteln (10, 11) versehen ist, um einerseits einen Vergleich zwischen dem Potential des zweiten Zwischenknotens (C) und dem des Kollektors des ersten Transistors (Q1), und andererseits zwischen dem Potential des ersten Zwischenknotens (A) und dem des Kollektors des zweiten Transistors (Q2) vorzunehmen, und um dem in einem Teil der ohmschen Ladung des zweiten Zweigs abgegebenen Strom einen ersten Strom (IO) hinzuzufügen, der sich nach und nach aufhebt, wenn das Potential des zweiten Zwischenknotens (C) über das des Kollektors des ersten Transistors (Q1) ansteigt, und einen zweiten Strom (I0'), der sich nach und nach aufhebt, wenn das Potential des Kollektors des zweiten Transistors (Q2) über das des ersten Zwischenknotens (A) ansteigt.

2. Spannungsverstärker nach Anspruch 1, **dadurch gekennzeichnet, daß** die Mittel zum Vergleich (10, 11) einerseits des Potentials des zweiten Zwischenknotens (C) mit dem des Kollektors des ersten Transistors (Q1) und andererseits des Potentials des ersten Zwischenknotens (A) mit dem des Kollektors des zweiten Transistors (Q2) respektive einerseits einen dritten und einen vierten, als Differentialpaar geschalteten Transistor (Q3, Q4), und andererseits einen fünften und einen sechsten, als Differentialpaar geschalteten Transistor (Q5, Q6) enthalten, während die Basis des dritten Transistors (Q3) mit dem zweiten Zwischenknoten (C), die des vierten Transistors (Q4) mit dem Kollektor des ersten Transistors (Q1) verbunden ist, die Basis des fünften Transistors (Q5) mit dem ersten Zwischenknoten (A), die des sechsten Transistors (Q6) mit dem Kollektor des zweiten Transistors (Q2) verbunden ist und die Kollektoren des vierten und fünften Transistors (Q4,Q5) mit dem zweiten Zwischenknoten (C) verbunden sind.

3. Spannungsverstärker (AD) zum Empfangen einer Eingangsspannung (Vin) und zum Liefern einer Ausgangsspannung (Vout), mit einer Verstärkerstufe, die einen ersten und einen zweiten Transistor (Q1,Q2) aufweist, als Differentialpaar geschaltet, während der erste Transistors (Q1) dazu bestimmt ist, an seiner Basis die Eingangsspannung (Vin) zu erhalten, der zweite Transistor (Q2) dazu bestimmt ist, an seiner Basis eine zur besagten Eingangsspannung (Vin) umgekehrte Spannung (-Vin) zu erhalten, der Kollektor des ersten Transistors (Q1) über eine positive Versorgungsklemme (VCC) mit einem ersten Zweig verbunden ist, der eine ohmsche Ladung aufweist, der Kollektor des zweiten Transistors (Q2), dazu bestimmt, die Ausgangsspannung (Vout) zu liefern, über dieselbe positive Versorgungsklemme (VCC) mit einem zweiten Zweig verbunden ist, der eine ohmsche Ladung aufweist, **dadurch gekennzeichnet, daß** der erste Zweig aus mindestens drei in Serie geschalteten ohmschen Elementen (R11, R12, R13) gebildet wird, die so an ihren Klemmen mindestens einen ersten und einen zweiten Zwischenknoten (A, B) zwischen der positiven Versorgungsklemme (VCC) und dem Kollektor des ersten Transistors (Q1) bilden, **daß** der zweite Zweig aus mindestens drei in Serie geschalteten ohmschen Elementen (R21, R22, R23) gebildet wird, die so an ihren Klemmen mindestens einen dritten und einen vierten Zwischenknoten (C, D) zwischen der positiven Versorgungsklemme (VCC) und dem Kollektor des zweiten Transistors (Q2) ausweisen, **daß** er mit Mitteln (10, 11) versehen ist, um einerseits einen Vergleich zwischen den Potentialen des Kollektors des ersten Transistors (Q1) und des vierten Zwischenknotens (D), und andererseits denen des Kollektors des zweiten Transistors (Q2) und des zweiten Zwischenknotens (B) vorzunehmen, und um dem in einem Teil der ohmschen Ladung des zweiten Zweigs abgegebenen Strom einen ersten Strom (IO) hinzuzufügen, der sich nach und nach aufhebt, wenn das Potential des vierten Zwischenknotens (D) über das des Kollektors des ersten Transistors (Q1) ansteigt, und einen zweiten Strom (I0'), der sich nach und nach aufhebt, wenn das Potential des Kollektors des zweiten Transistors (Q2) über das des ersten Zwischenknotens (B) ansteigt.

4. Spannungsverstärker (AD) nach Anspruch 3, **dadurch gekennzeichnet, daß** die Mittel zum Vergleich (10, 11) einerseits der Potentiale des Kollektors des ersten Transistors (Q1) mit dem vierten Zwischenknoten (D) und andererseits der Potentiale des Kollektors des zweiten Transistors (Q2) mit dem zweiten Zwischenknoten (B) respektive einerseits einen dritten und einen vierten, als Differentialpaar geschalteten Transistor (Q3, Q4), und andererseits einen fünften und einen sechsten, als Differentialpaar geschalteten Transistor (Q5, Q6) enthalten, während die Basis des dritten Transistors (Q3) mit dem vierten Zwischenknoten (D), die des vierten Transistors (Q4) mit dem Kollektor des ersten Transistors (Q1) verbunden ist, die Basis des fünften Transistors (Q5) mit dem zweiten Zwischenknoten (B), die des sechsten Transistors (Q6) mit dem Kollektor des zweiten Transistors (Q2) verbunden ist und die Kollektoren des vierten und fünften Transistors (Q4, Q5) mit einem der Zwischenknoten des zweiten Zweigs verbunden sind.

5. Spannungsverstärker (AD) nach Anspruch 4, **dadurch gekennzeichnet, daß** die Kollektoren des vierten und fünften Transistors (Q4, Q5) mit dem dritten Zwischenknoten (C) verbunden sind.

6. Spannungsverstärkers (AD) nach einem der Ansprüche 3 bis 4, **dadurch gekennzeichnet, daß** die ohmschen Elemente (R12,R22) zur Trennung einerseits der ersten von den zweiten Zwischenknoten (A, B) und andererseits der dritten von den vierten Zwischenknoten (C, D) einen selben nominalen Wert der Bezeichnung R aufweisen, **daß** die ohmschen Elemente (R11, R21) zur Trennung einerseits der positiven Versorgungsklemme (VCC) vom ersten Zwischenknoten (A) und andererseits der positiven Versorgungsklemme (VCC) vom dritten Zwischenknoten (C) einen selben nominalen Wert aufweisen, der kleiner als R ist, und **daß** die ohmschen Elemente (R13,R23) zur Trennung einerseits des zweiten Zwischenknotens (B) vom Kollektor des ersten Transistors (Q1) und andererseits des vierten Zwischenknotens (D) vom Kollektor des zweiten Transistors (Q2) einen selben nominalen Wert aufweisen, der kleiner als R ist.

7. Spannungsverstärkers (AD) nach einem der Ansprüche 3 bis 5, **dadurch gekennzeichnet, daß** die ohmschen Elemente (R12, R22) zur Trennung einerseits der ersten von den zweiten Zwischenknoten (A, B) und andererseits der dritten von den vierten Zwischenknoten (C, D) einen selben nominalen Wert der Bezeichnung R aufweisen, **daß** die ohmschen Elemente (R11, R13, R23) zur Trennung der positiven Versorgungsklemme (VCC) vom ersten Zwischenknoten (A) und des zweiten Zwischenknotens (B) vom Kollektor des ersten Transistors (Q1) sowie die zur Trennung der positiven Versorgungsklemme (VCC) vom dritten Zwischenknoten (C) und des vierten Zwischenknotens (D) vom Kollektor des zweiten Transistors (Q2) einen selben nominalen Wert aufweisen, der kleiner als R ist.

8. Spannungsverstärkers (AD) nach einem der Ansprüche 1 bis 7, **dadurch gekennzeichnet, daß** die ohmschen Elemente, die die Ladung der Verstärkerstufe bilden, Widerstände sind.

9. Analog/Digital-Konverter, für den Erhalt einer analogen Eingangsspannung (Vin, -Vin) differentialer Art zur Konvertierung in ein digitales Ausgangssignal (Vout (0...7)) bestimmt, bestehend aus:
. einem Eingangsverstärker (AD), bestimmt für den Erhalt der analogen Eingangsspannung (Vin, -Vin) und die Lieferung einer analogen Ausgangsspannung,
. einer Widerstandsstufe (100), in Serie zwischen einer positiven (Vtop) und einer negativen (Vbot) Versorgungsklemme angeordnet, während die Widerstände dazu bestimmt sind, an ihre Zwischenknoten eine Vielzahl an sogenannten Bezugsspannungen (V0,...V63) zu liefern,
. einer Vergleicherstufe (200), dazu bestimmt, einen Vergleich zwischen der Ausgangsspannung des Eingangsverstärkers und einer der Bezugsspannungen durchzuführen,
. einer Speicherstufe (300), dazu bestimmt, die Ergebnisse der besagten Vergleiche zu speichern,
. einem binären Kodierer (400), dazu bestimmt, die in der Speicherstufe (300) gespeicherten Informationen zu erhalten und das digitale Ausgangssignal (Vout(0...7)) des Konverters zu liefern,
**dadurch gekennzeichnet, daß** der Eingangsverstärker (AD) einem beliebigen der Ansprüche 1 bis 8 entspricht.

## Claims

1. A voltage amplifier (AD) intended to receive an input voltage (Vin) and to supply an output voltage (Vout), which voltage amplifier comprises an amplifier stage including a first and a second transistor (Q1,Q2) arranged as a differential pair, the base of the first transistor (Q1) being intended to receive the input voltage (Vin), the base of the second transistor (Q2) being intended to receive a voltage (-Vin) opposed to said input voltage (Vin), the collector of the first transistor (Q1) being connected to a positive power supply terminal (VCC) by means of a first branch comprising a resistive load, the collector of the second transistor (Q2), intended to supply the output voltage (Vout), being connected to the positive power supply terminal (VCC) by means of a second branch comprising a resistive load, the voltage amplifier (AD) being **characterized in that** the first branch is constituted by at least two series-arranged resistive elements (R11,R12) featuring at least a first intermediate node (A) between the positive power supply terminal (VCC) and the collector of the first transistor (Q1), **in that** the second branch is constituted by at least two series-arranged resistive elements (R21,R22) featuring at least a second intermediate node (C) between the positive power supply terminal (VCC) and the collector of the second transistor (Q2), **in that** the voltage amplifier is provided with means (10,11) for comparing the potential of the second intermediate node (C) with that of the collector of the first transistor (Q1), on the one hand, and the potential of the first intermediate node (A) with that of the collector of the second transistor (Q2), on the other hand, and for adding, to the current supplied in a portion of the resistive load of the second branch, a first current (IO) which is progressively reduced to zero when the potential of the second intermediate node (C) exceeds that of the collector of the first transistor (Q1), and a second current (IO') which is progressively reduced to zero when the potential of the collector of the second transistor (Q2) exceeds that of the first intermediate node (A).

2. A voltage amplifier as claimed in claim 1, **characterized in that** the means (10,11) for comparing the potential of the second intermediate node (C) with that of the collector of the first transistor (Q1), on the one hand, and the potential of the first intermediate node (A) with that of the collector of the second transistor (Q2), on the other hand, respectively comprise a third and a fourth transistor (Q3,Q4) arranged as a differential pair, and a fifth and a sixth transistor (Q5,Q6) arranged as a differential pair, the base of the third transistor (Q3) being connected to the second intermediate node (C) and that of the fourth transistor (Q4) being connected to the collector of the first transistor (Q1), the base of the fifth transistor (Q5) being connected to the first intermediate node (A) and that of the sixth transistor (Q6) being connected to the collector of the second transistor (Q2), the collectors of the fourth and the fifth transistor (Q4,Q5) being connected to the second intermediate node (C).

3. A voltage amplifier (AD) intended to receive an input voltage (Vin) and to supply an output voltage (Vout), which voltage amplifier comprises an amplifier stage including a first and a second transistor (Q1,Q2) arranged as a differential pair, the base of the first transistor (Q1) being intended to receive the input voltage, the base of the second transistor (Q2) being intended to receive a voltage (-Vin) opposed to said input voltage (Vin), the collector of the first transistor (Q1) being connected to a positive power supply terminal (VCC) by means of a first branch comprising a resistive load, the collector of the second transistor (Q2), intended to supply the output voltage (Vout), being connected to the same positive power supply terminal (VCC) by means of a second branch comprising a resistive load, **characterized in that** the first branch is constituted by at least three series-arranged resistive elements (R11,R12,R13) featuring at their terminals at least a first and a second intermediate node (A,B) between the positive power supply terminal (VCC) and the collector of the first transistor (Q1), **in that** the second branch is constituted by at least three series-arranged resistive elements (R21,R22,R23) featuring at their terminals at least a third and a fourth intermediate node (C,D) between the positive power supply terminal (VCC) and the collector of the second transistor (Q2), **in that** the voltage amplifier is provided with means (10,11) for comparing the potentials of the collector of the first transistor (Q1) and the fourth intermediate node (D), on the one hand, and those of the collector of the second transistor (Q2) and the second intermediate node (B), on the other hand, and for adding to the current supplied in a portion of the resistive load of the second branch, a first current (IO) which is progressively reduced to zero when the potential of the fourth intermediate node (D) exceeds that of the collector of the first transistor (Q1), and a second current (IO') which is progressively reduced to zero when the potential of the collector of the second transistor (Q2) exceeds that of the second intermediate node (B).

4. A voltage amplifier (AD) as claimed in claim 3, **characterized in that** the means (10,11) for comparing the potentials of the collector of the first transistor (Q1) and the fourth intermediate node (D), on the one hand, and the potentials of the collector of the second transistor (Q2) and the second intermediate node (B), on the other hand, respectively comprise a third and a fourth transistor (Q3,Q4) arranged as a differential pair, and a fifth and a sixth transistor (Q5,Q6) arranged as a differential pair, the base of the third transistor (Q3) being connected to the fourth intermediate node (D) and that of the fourth transistor (Q4) being connected to the collector of the first transistor (Q1), the base of the fifth transistor (Q5) being connected to the second intermediate node (B) and that of the sixth transistor (Q6) being connected to the collector of the second transistor (Q2), the collectors of the fourth and the fifth transistor (Q4,Q5) being connected to one of the intermediate nodes of the second branch.

5. A voltage amplifier as claimed in claim 4, **characterized in that** the collectors of the fourth and the fifth transistor (Q4,Q5) are connected to the third intermediate node (C).

6. A voltage amplifier (AD) as claimed in any one of claims 3 to 5, **characterized in that** the resistive elements (R12,R22) between the first and the second intermediate nodes (A,B), on the one hand, and between the third and the fourth intermediate nodes (C,D), on the other hand, have the same nominal value R, **in that** the resistive elements (R11,R21) between the positive power supply terminal (VCC) and the first intermediate node (A), on the one hand, and between the positive power supply terminal (VCC) and the third intermediate node (C), on the other hand, have the same nominal value which is smaller than R, and **in that** the resistive elements (R13,R23) between the second intermediate node (B) and the collector of the first transistor (Q1), on the one hand, and between the fourth intermediate node (D) and the collector of the second transistor (Q2), on the other hand, have the same nominal value which is smaller than R.

7. A voltage amplifier (AD) as claimed in any one of claims 3 to 5, **characterized in that** the resistive elements (R12,R22) between the first and second intermediate nodes (A,B), on the one hand, and between the third and fourth intermediate nodes (C,D), on the other hand, have the same nominal value R, **in that** the resistive elements (R11,R13,R21,R23) between the positive power supply terminal (VCC) and the first intermediate node (A) and between the second intermediate node (B) and the collector of the first transistor (Q1), as well as those between the positive power supply terminal (VCC) and the third intermediate node (C) and between the fourth intermediate node (D) and the collector of the second transistor (Q2) have the same nominal value which is smaller than R.

8. A voltage amplifier (AD) as claimed in any one of claims 1 to 7, **characterized in that** the resistive elements constituting the load of the amplifier stage are resistors.

9. An A/D converter intended to receive an analog input voltage (Vin, -Vin) of a differential nature, to be converted into a digital output signal (Vout(0:7)), comprising:
. an input amplifier (AD) intended to receive the analog input voltage (Vin,-Vin), and to supply an analog output voltage,
. a resistance ladder (100) arranged in series between a positive (Vtop) and a negative (Vbot) power supply terminal, in which the resistors are intended to supply a plurality of reference voltages (V0,...V63) at their intermediate nodes,
. a comparator stage (200) in which each comparator is intended to perform a comparison between the output voltage of the input amplifier and one of the reference voltages;
. a memory stage (300) intended to store the results of said comparisons,
. a binary encoder (400) intended to receive the information stored in the memory stage (300) and to supply the digital output signal (Vout(0:7))of the converter,
**characterized in that** the input amplifier (AD) is an amplifier as claimed in any one of claims 1 to 8.
